# EUROPEAN PATENT SPECIFICATION

(11) **EP 2 589 056 B1**
(45) Date of publication and mention of the grant of the patent: **26.07.2017**
(21) Application number: 11730621.7
(22) Date of filing: 29.06.2011
(51) Int. Cl.: H01G 9/20, H01L 51/46

(54) **HIGH EFFICIENCY DYE-SENSITIZED SOLAR CELLS**
LEISTUNGSSTARKE FARBSTOFFSENSIBILISIERTE SOLARZELLEN
CELLULES SOLAIRES SENSIBILISÉES PAR COLORANT À RENDEMENT ÉLEVÉ

(30) Priority: 29.06.2010 US 359619 P
(43) Date of publication of application: 08.05.2013
(73) Proprietor: Dyenamo AB, 187 34 Täby (SE)
(72) Inventor: GIBSON, Elizabeth, Nottingham Nottinghamshire NG7 2PL (GB); FELDT, Sandra, S-194 52 Upplands Väsby (SE); GABRIELSSON, Erik, S-111 60 Stockholm (SE)
(74) Representative: Awapatent AB
(86) International application number: PCT/EP2011/060886
(87) International publication number: WO 2012/001033

(56) References cited:
- CN-A- 101 735 640
- CN-A- 101 735 641
- US-A1- 2009 250 115
- US-A1- 2010 122 729
- BENJAMIN M. KLAHR ET AL: "Performance Enhancement and Limitations of Cobalt Bipyridyl Redox Shuttles in Dye-Sensitized Solar Cells", JOURNAL OF PHYSICAL CHEMISTRY C, vol. 113, no. 31, 1 July 2009 (2009-07-01) , pages 14040-14045, XP55009293, ISSN: 1932-7447, DOI: 10.1021/jp903431s cited in the application
- SHAWN A. SAPP ET AL: "Substituted Polypyridine Complexes of Cobalt(II/III) as Efficient Electron-Transfer Mediators in Dye-Sensitized Solar Cells", JOURNAL OF THE AMERICAN CHEMICAL SOCIETY, vol. 124, no. 37, 24 August 2002 (2002-08-24), pages 11215-11222, XP55009304, ISSN: 0002-7863, DOI: 10.1021/ja027355y cited in the application
- MICHAEL J. DEVRIES ET AL: "Dye-Sensitized Solar Cells: Driving-Force Effects on Electron Recombination Dynamics with Cobalt-Based Shuttles", LANGMUIR, vol. 26, no. 11, 11 February 2010 (2010-02-11), pages 9082-9087, XP55009301, ISSN: 0743-7463, DOI: 10.1021/la904643t cited in the application
- XIAO JIANG ET AL: "Structural Modification of Organic Dyes for Efficient Coadsorbent-Free Dye-Sensitized Solar Cells", JOURNAL OF PHYSICAL CHEMISTRY C, vol. 114, no. 6, 22 January 2010 (2010-01-22), pages 2799-2805, XP55009292, ISSN: 1932-7447, DOI: 10.1021/jp908552t cited in the application

## Description

### FIELD OF THE INVENTION

The present invention relates to a dye-sensitized solar cell comprising a mesoporous semi-conductor sensitized with a light-absorbing dye, a counter electrode, and an electrolyte comprising a redox mediator.

### BACKGROUND OF THE INVENTION

Dye-sensitized solar cells (DSC) have gained a great interest as cost-effective alternatives to silicon-based photovoltaic devices. In the DSC, light is absorbed by a dye molecule anchored to a mesoporous wide band-gap semiconductor, normally TiO₂. Upon light absorption the photoexcited dye injects an electron into the conduction band of the semiconductor and its resulting oxidized state is regenerated by a redox mediator in a surrounding electrolyte. So far the best cell performances in DSCs of about 11 % conversion efficiency have been obtained with ruthenium based dyes and the iodide/triiodide redox couple.

For large scale manufacturing of dye-sensitized solar cells (DSCs) it is, however, of interest to find an alternative redox mediator to the corrosive iodide/triiodide redox couple. The I⁻/I₃⁻ system is limited by its relatively low solution redox potential, its corrosiveness towards metal compounds and by competitive absorption of the light by triiodide. The high series resistance of the transparent conductive oxide substrate limits the performance of large area DSCs and modules and one way to reduce the high resistance is to apply current collection metal grids over the substrate. The scale up of DSCs and the module stability is therefore limited by the corrosiveness of the iodide/triiodide redox couple towards most metals and sealing materials. Several redox mediators have so far been examined as alternative redox couples in DSCs in order to avoid the problems associated with the I⁻/I₃⁻system and the best alternative redox mediator reported to date is a disulfide/thiolate redox couple that yields an efficiency of 6.4 % under full sunlight.

Klahr et al. (J. Phys. Chem. C; 2009: 113;14040-14045) presents DSCs using Cobalt Bipyridyl Redox Shuttles. Moreover, Sapp et al. (J. Am. Chem. Soc.; 2002;124:11215-11222) present DSCs using tris(4,4'-di-*tert*-butyl-2,2'-dipyridyl)-cobalt(II/III) perchlorate. Furthermore, DeVries et al. (Langmuir; 2010; 26; 9082-9087) present DSCs using different cobalt shuffels. Jiang et al. (J. Phys. Chem. C; 2010; 114;2799-2805) presents a work where different sensitizers has been used in DSCs.

### SUMMARY OF THE INVENTION

In view of the above-mentioned and other drawbacks of the prior art, a general object of the present invention is to overcome at least one of the above-mentioned problems, and to provide a dye-sensitized solar cell having improved life-time and efficiency.

According to the present invention there is provided a dye-sensitized solar cell comprising a mesoporous semi-conductor sensitized with a light-absorbing dye, a counter electrode, and an electrolyte comprising a redox mediator, characterized in that an organic light-absorbing dye is used in combination with a one-electron transfer redox mediator.

One electron outer sphere redox couples such as cobalt complexes are interesting alternative redox mediators since they show weak visible light absorption and are less aggressive towards metal compounds than iodine. Unfortunately, the use of one electron redox mediators have been shown to lead to enhanced recombination with electrons in the TiO₂ conduction band. Recombination of photoinjected electrons with cobalt(III) is , however, anticipated to be slow due to a change in spin upon reduction to cobalt(II). Previous investigations suggest that the performance of cobalt redox mediators in DSCs is limited by slow dye regeneration, mass transport problems in the mesoporous TiO₂ electrode, as well as by rapid recombination from electrons in the TiO₂ conduction band to the cobalt(III) species. The rate of dye regeneration has been increased by the use of co-mediator system with a fast redox mediator (ferrocene or polypyridine Fe) in conjugation with a CoII complex. Much research has recently been focused on passivating the TiO₂ surface using atomic layer deposition (ALD) in order to diminish the fast recombination processes occurring in combination with cobalt redox mediators. There still remains a question mark, however, as to whether the main drawback with the cobalt mediators is regeneration, mass transport or recombination problems.

The present invention is based on the realization that a highly efficient dye-sensitized solar cell is achieved by combining an organic light-absorbing dye with a one electron transfer redox mediator, thereby avoiding the above-mentioned drawbacks associated iodide/triiodide redox couple. Further, according to the invention, organic dyes with high extinction coefficient can advantageously be used instead of standard ruthenium sensitizers to build thin films DSCs in order to overcome mass transport and recombination limitations associated with cobalt polypyridine redox mediators.

Advantageously, the organic dye may comprise steric groups that suppress recombination between electrons in the semi-conductor and acceptor species in the electrolyte. In embodiments of the dye-sensitized solar cell according to the invention, the organic dye may advantageously comprise bulky alkoxy electron-donating substituents.

By using a dye with steric groups, such as bulky alkoxy groups, recombination is efficiently suppressed, and also, allowing the use of cobalt redox mediator with less steric bulk and thereby the above-mentioned mass transport problems are also avoided.

In embodiments of the dye-sensitized solar cell according to the invention, the organic dye has the following structure: 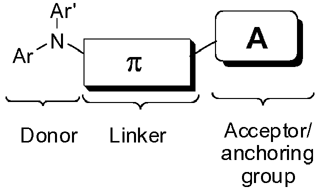 wherein the donor may comprise a triarylamine group having electron donating aromatic substituents Ar and Ar', wherein A may be an electron withdrawing group, and wherein π may be a series of one or more conjugated units which electronically links the donor and acceptor parts of the dye molecules.

In embodiments of the dye-sensitized solar cell according to the invention, the Ar and Ar' may be any one of phenyl, thiophene, furan, naphthyl-derivatives and other polycyclic aromatic hydrocarbons, fused heterocyclic systems and their corresponding oligomeric variants.

In embodiments of the dye-sensitized solar cell according to the invention, the organic dye may advantageously comprise a triphenylamine (TPA).

Advantageously, the A in the structure above may comprise a carboxylic acid functions such as cyanoacrylic acid and rhodanine-3-acetic acid, or a phosphorous or sulfur based anchoring group, such as in the form of a phosphonate or sulfonate.

Moreover, π, in the above structure, may comprise a combination of 5 or 6-membered unsaturated (hetero)cyclic units containing up to four heteroatoms from group 14-16 of the periodic table per ring, primarily phenyl, thiophene, furan, pyrrole, thiazole and oxazole, or their fused and polycyclic variants such as thieno[3,2-*b*]thiophene, dithieno[3,2-*b*:2',3'-*d*]thiophene, phenothiazine, phenoxazine, 4H-silolo[3,2-*b*:4,5-*b*']dithiophene and carbazole.

Advantageously, in embodiments of the dye-sensitized solar cell according to the invention, the the organic dye may be D29 having the following formula: 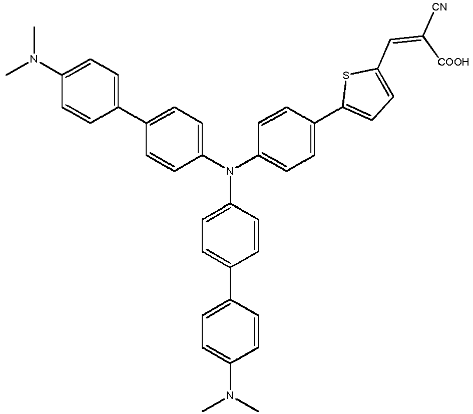 or the organic dye may be D35 having the following formula:

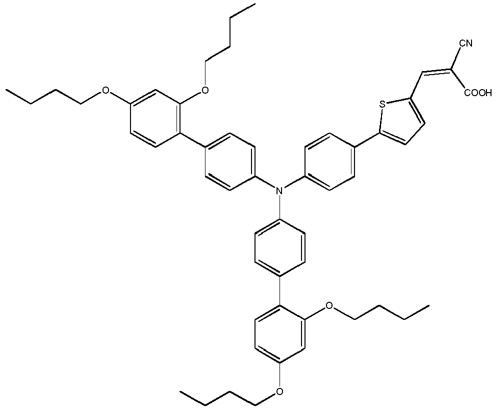

In embodiments of the dye-sensitized solar cell according to the invention, the organic dye has an extinction coefficient of at least 70000 M⁻¹cm⁻¹.

In embodiments of the dye-sensitized solar cell according to the invention, the the one-electron transfer redox mediator may advantageously be a cobalt complex with a central cobalt atom with organic ligands, such as, for example, a cobalt polypyridine complex.

In embodiments of the dye-sensitized solar cell according to the invention, the material of the counter electrode comprises platinum.

In embodiments of the dye-sensitized solar cell according to the invention, the material of the counter electrode comprises carbon.

In embodiments of the dye-sensitized solar cell according to the invention, the mesoporous semiconductor may be TiO₂.

Matching the steric bulk of triphenylamine based organic sensitizers and cobalt polypyridine redox mediators was found to minimize recombination and mass transport problems in cobalt based DSCs. The bulky alkoxy groups introduced on the organic sensitizer D35 was shown to efficiently suppress recombination, allowing the use of cobalt redox mediators with a less steric bulk. By building thin film DSCs sensitized with dyes with high extinction coefficient can earlier problems associated with cobalt redox mediators, such as fast recombination and mass transport limitations efficiently be avoided. The best efficiency for DSCs sensitized with D35 employing a [Co(bpy)₃]^{3+/2+} based electrolyte of 6.3 % at full sunlight and 7.8 % at 1/10 sun match the highest efficiency obtained so far with iodide-free electrolytes. One advantage of using one electron redox couples in DSCs is that the driving force for regeneration is expected to be lower than that for the iodide/triiodide redox shuttle, and the absorption of the dye can therefore be broadened by tuning the HOMO level of the dye. The spectral response of TPA based organic sensitizer can be extended by increasing the linker conjugation in between the donor and acceptor groups. The current is in addition higher in DSCs employing cobalt redox mediators since the cobalt complexes absorb less light than iodide/triiodide.

Cobalt polypyridyl complexes are promising alternative redox mediators to the iodide/triiodide redox couple for large scale manufacturing of DSCs since they are less aggressive towards silver contacts and sealing materials. The efficiency and stability of modules of DSCs containing cobalt polypyridine redox couples can be increased since the non corrosive nature of the complexes allows the use of current collector metal grids that reduces the high series resistance of the transparent conductive oxide substrate. DSCs sensitized with organic dyes employing cobalt polypyridine redox mediators are promising for low light intensity applications since the voltage and efficiency is kept high at lower light intensities. Mass transport limitations are also efficiently avoided at lower light intensities and the stability of the devices can be extended by using a more viscous electrolyte. The Voc of the devices is higher than that of the iodide/triiodide redox shuttle and can easily be tuned as the large amount of commercial available ligands makes it possible to adjust the redox potential by changing the coordination sphere of the complexes. One prospect of employing one electron outer sphere redox mediators in DSCs is that the material of the catalyst on the counter electrode can be changed to a less expensive one.

### BRIEF DESCRIPTION OF THE DRAWINGS

These and other aspects of the present invention will now be described in more detail, with reference to the appended figures, wherein:

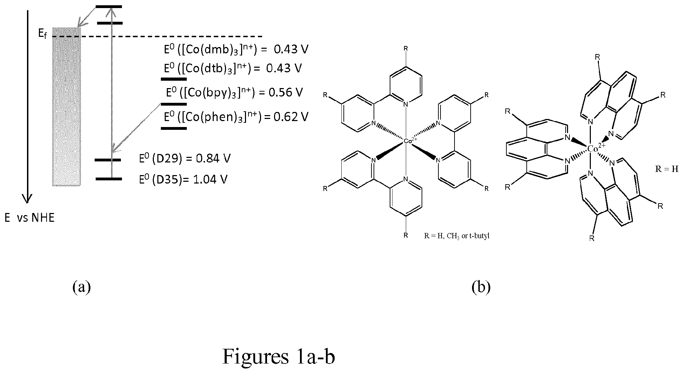

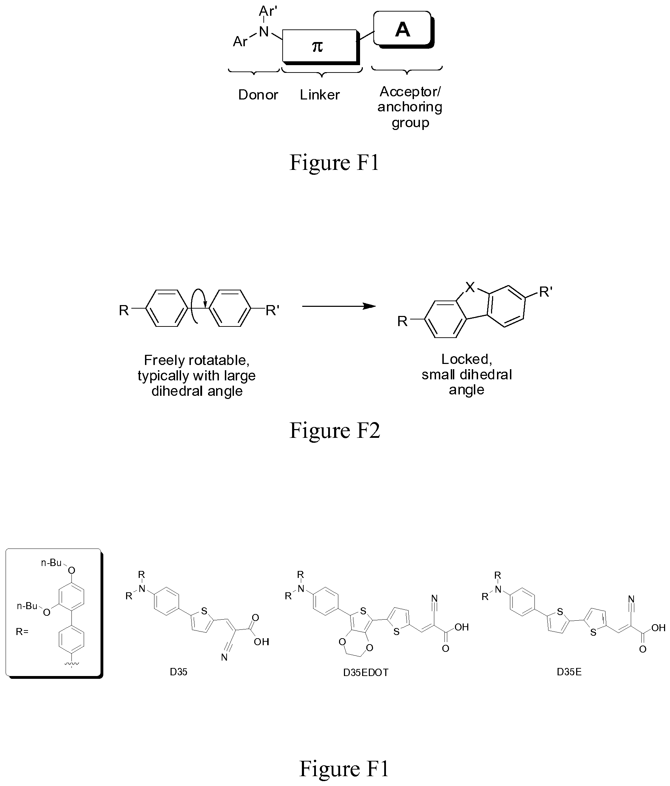

Figure 1a shows a schematic energy diagram for a nanostructured TiO₂ electrode sensitized with D35 or D29 employing [Co(bpy)₃]^{2+/3}+, [Co(dmb)₃]^{2+/3+}, [Co(dtb)₃]^{2+/3+} and [Co(phen)₃]^{2+/3+} based electrolytes, and Figure 1b shows the chemical structure of the different cobalt polypyridyl redox couples employed herein;

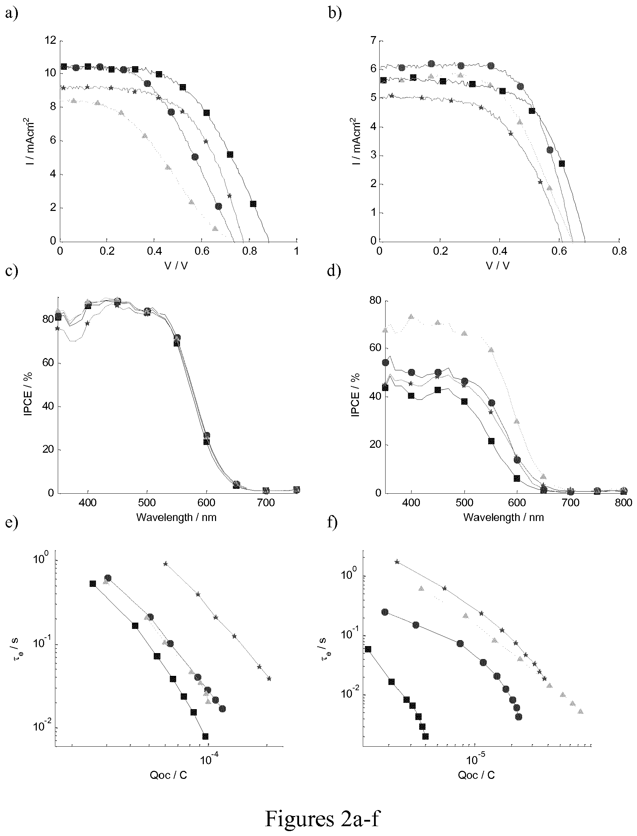

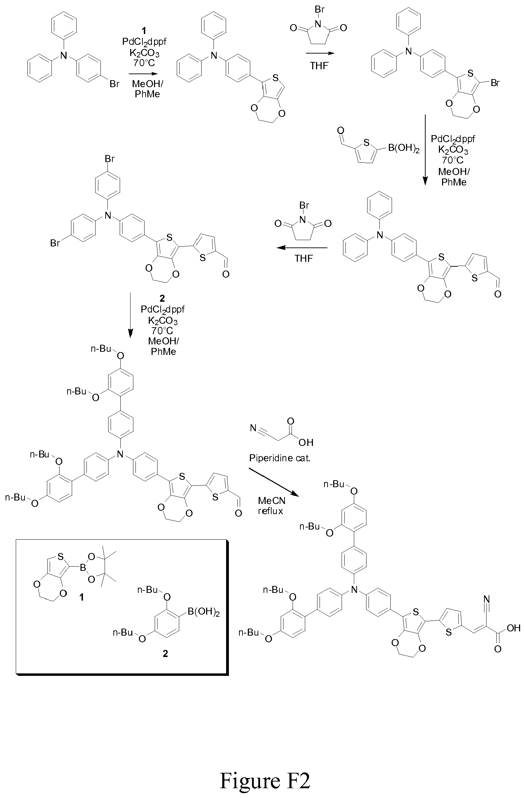

Figures 2a-f showing current density versus applied potential curves under AM1.5G illumination for DSCs sensitized with (a) D35 and (b) D29; spectra of incident photon to current efficiency (IPCE) for DSCs sensitized with (c) D35 and (d) D29; electron lifetime as a function of extracted charge under open circuit conditions for DSCs sensitized with (e) D35 and (f) D29. The electrolytes were [Co(bpy)₃]^{2+/3+} (blue squares), [Co(dmb)₃]^{2+/3+} (red circles), [Co(dtb)₃]^{2+/3+} (green triangles) and iodide/triiodide (magenta stars);

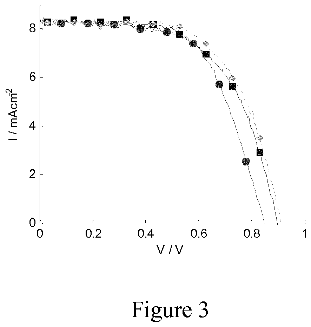

Figure 3 shows current density versus applied potential curves under AM1.5G illumination for DSCs sensitized with D35 employing [Co(bpy)₃]^{2+/3+} (blue squares), [Co(dmb)₃]^{2+/3+} (red circles) and [Co(phen)₃]^{2+/3+} (green diamonds) based electrolytes;

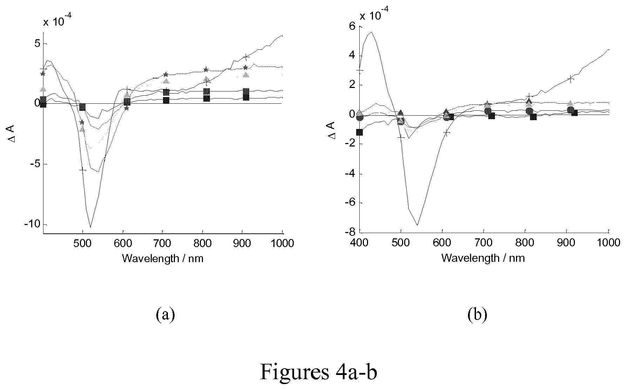

Figures 4a-b showing PIA spectra of TiO₂ sensitized with (a) D35 (b) D29 using [Co(bpy)₃]^{2+/3+} (blue squares), [Co(dmb)₃]^{2+/3+} (red circles), [Co(dtb)₃]^{2+/3+} (green triangles) and iodide/triiodide (magenta stars) based electrolytes. Black cross is the spectra of the dyes in air. The electrolyte was 0.1 M Co(xxx)₃(ClO₄)₂, 0.01 M Co(xxx)₃(ClO₄)₃, 0.1 M LiClO₄ and 0.2 M TBP in acetonitrile;

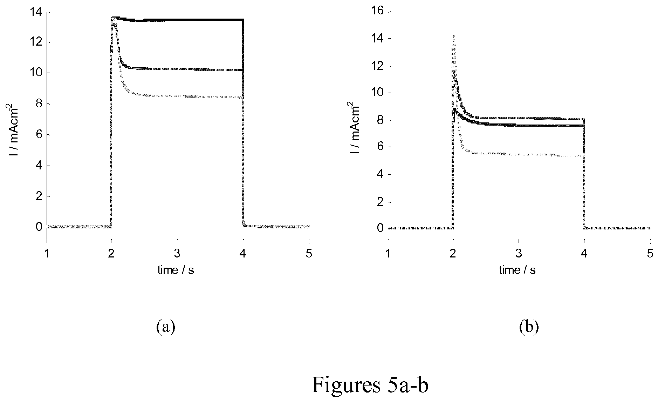

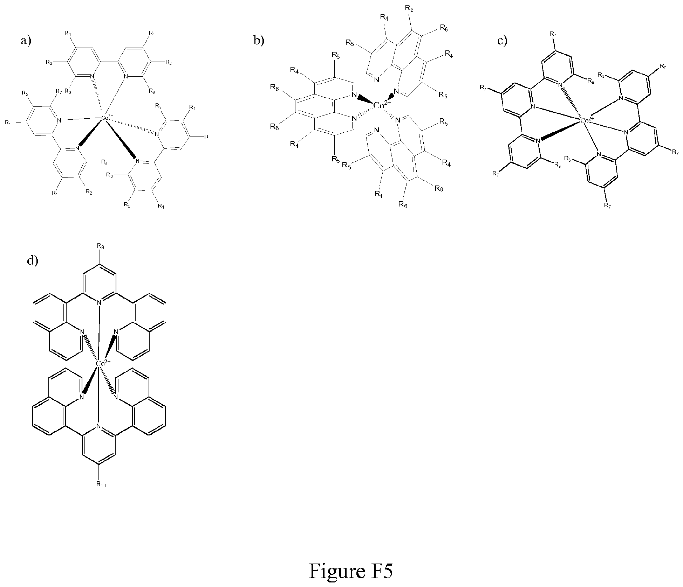

Figures 5a-b show plots of current transients for DSCs sensitized with (a) D35 and (b) D29 using [Co(bpy)₃]^{2+/3+} (blue solid line), [Co(dmb)₃]^{2+/3+} (red dashed line) and [Co(dtb)₃]^{2+/3+} (green dotted line) based electrolytes;

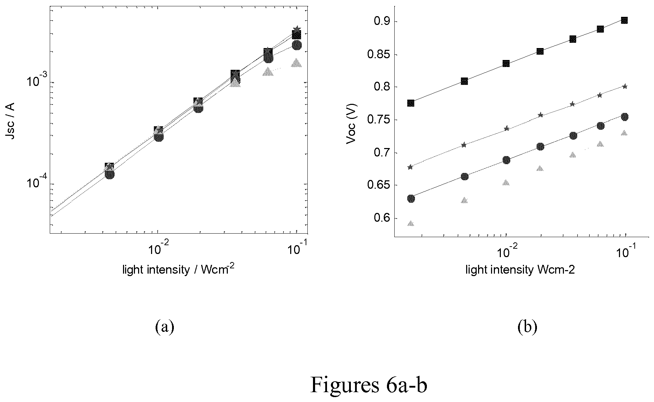

Figures 6a-b showing light intensity dependence of (a) the current density under short circuit conditions and (b) the open circuit voltage for DSCs sensitized with D35 using [Co(bpy)₃]^{2+/3+} (blue squares), [Co(dmb)₃]^{2+/3+} (red circles), [Co(dtb)₃]^{2+/3+} (green triangles) and iodide/triiodide (magenta stars) based electrolytes;

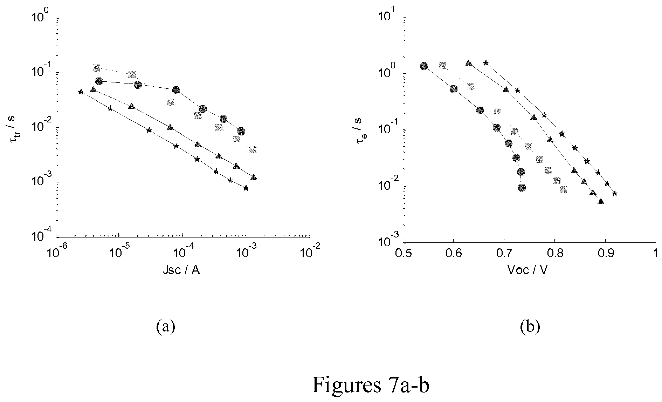

Figures 7a-b showing: (a) transport time as a function of short circuit current and (b) electron lifetime as a function of open circuit voltage for [Co(bpy)₃]^{2+/3+} based DSCs sensitized with D35 with different thickness of TiO₂. The film thickness was 4 µm (blue stars), 6 µm (red triangles), 15 µm (green squares) and 24 µm (magenta circles);

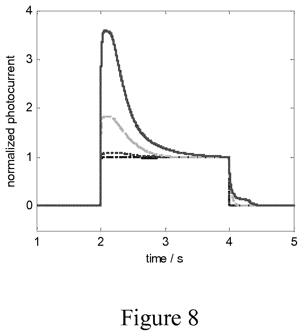

Figure 8 shows plots of current transients for [Co(bpy)₃]^{2+/3+} based DSCs sensitized with D35 with different thickness of TiO2. The film thickness was 4 µm (blue dashed-dotted line), 6 µm (red dotted line), 15 µm (green dashed line) and 24 µm (magenta solid line);

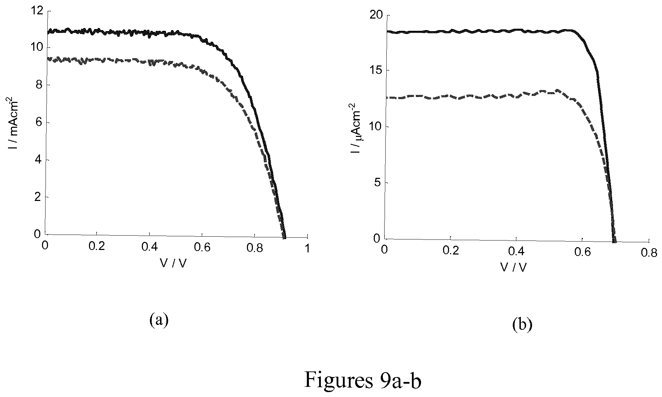

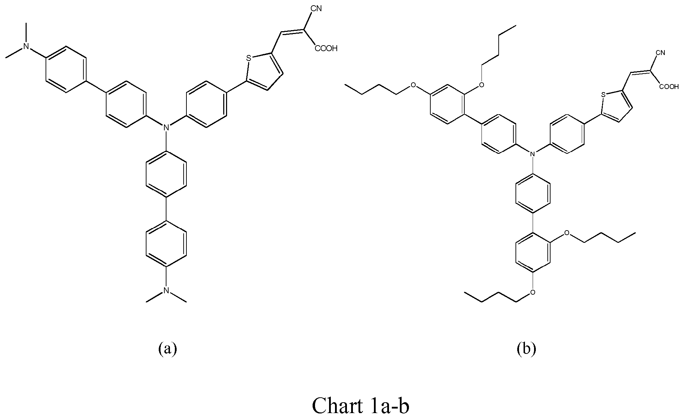

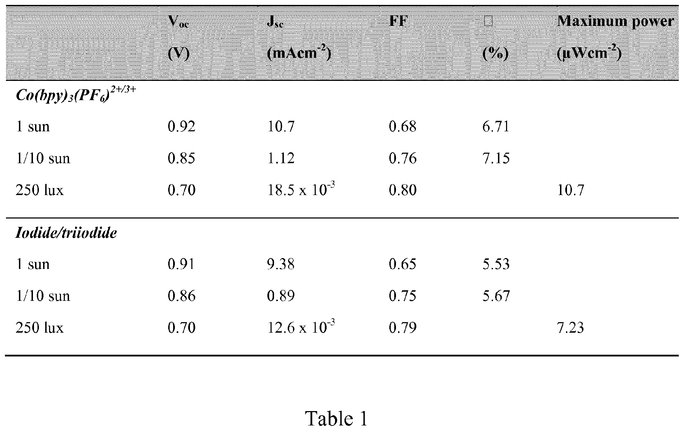

Figures 9a-b showing current density versus applied potential curves under (a) 1 sun AM1.5G and (b) 250 lux illumination for DSCs sensitized with D35 using [Co(bpy)₃]^{2+/3+} (blue solid line) and iodide/triiodide (red dashed line) based electrolytes. The electrolytes were 0.5 M Co(bpy)₃(PF₆)₂, 0.1 M Co(bpy)₃(PF₆)₃, 0.5 M TBP and 0.1 M LiClO₄ in acetonitrile, or 0.6 M 1-butyl-3-methylimidazoliumiodide, 0.03 M h, 0.5 M TBP and 0.1 M guanidinium thiocyanate in acetonitrile, respectively;
   Chart 1 shows the chemical structure of (a) D29 and (b) D35;
   Table 1 shows Current - Voltage characteristics of DSCs sensitized with D35 using [Co(bpy)₃]^{2+/3+} and iodide/triiodide based electrolytes measured under 1 sun AM1.5G, 1/10 sun AM1.5G and 250 lux illumination;
   Figure F1 shows the general structure of a triarylamine dye for use in cobalt-based electrolytes;
   Figure F2 schematically shows how rigidifying the structure of a dye can be achieved by linkage in ortho-position;
   Figure F3 shows examples of extended linker dyes designed to broaden the absorption;
   Figure F4 schematically shows the synthesis of an extended linker dye; and
   Figure F5 shows the molecular structure of (a) bipyridine, (b) phenanthroline, (c) terpyridine and (d) 2,6-di(quinolin-8-yl-pyridine) cobalt (II) complexes.

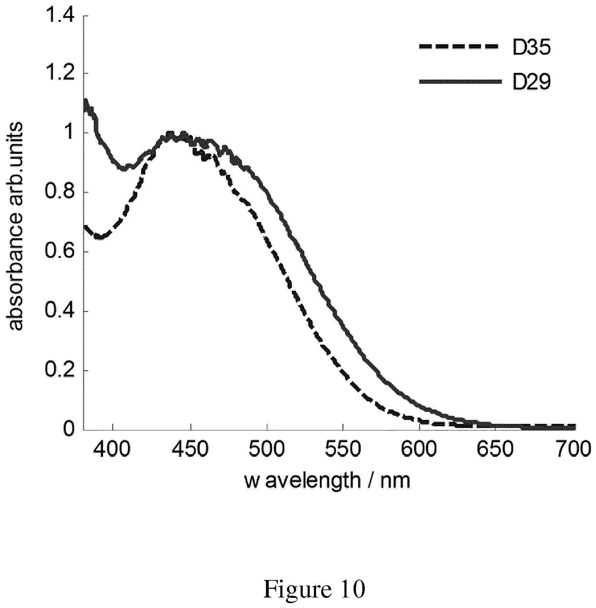

Figure 10 shows the normalized absorption spectra of D29 (solid line) and D35 (dashed line) adsorbed onto

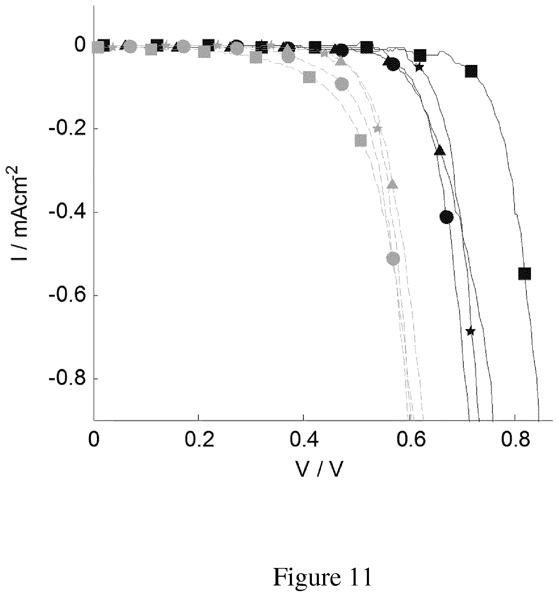

Figure 11 shows the dark current density versus applied potential curves for DSCs sensitized with (a) D35 (solid line) and (b) D29 (dashed line) employing [Co(bpy)₃]^{2+/3+} (squares), [Co(dmb)₃]^{2+/3+} (circles), [Co(dtb)₃]^{2+/3+} (triangles) and iodide/triiodide (stars) based electrolytes.

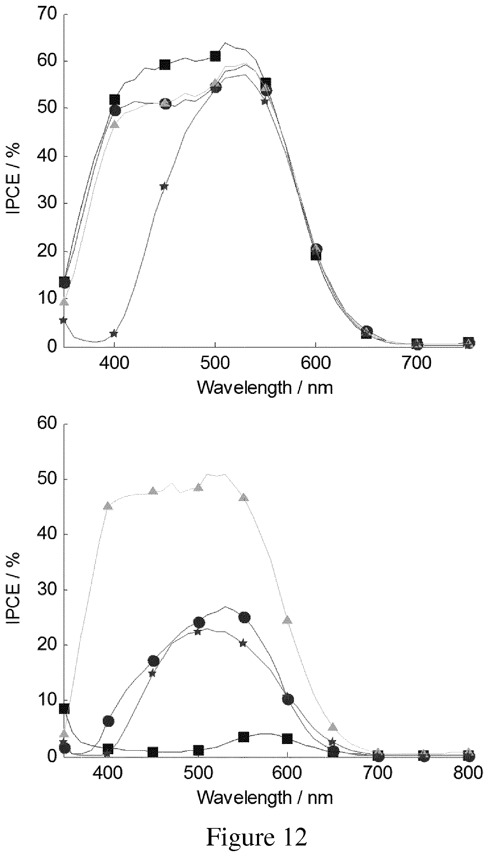

Figure 12 shows the spectra of incident photon to current efficiency (IPCE) from CE illumination for DSCs sensitized with (a) D35 and (b) D29 employing [Co(bpy)₃]^{2+/3+} (squares), [Co(dmb)₃]^{2+/3+} (circles), [Co(dtb)₃]^{2+/3+} (triangles) and iodide/triiodide (stars) based electrolytes.

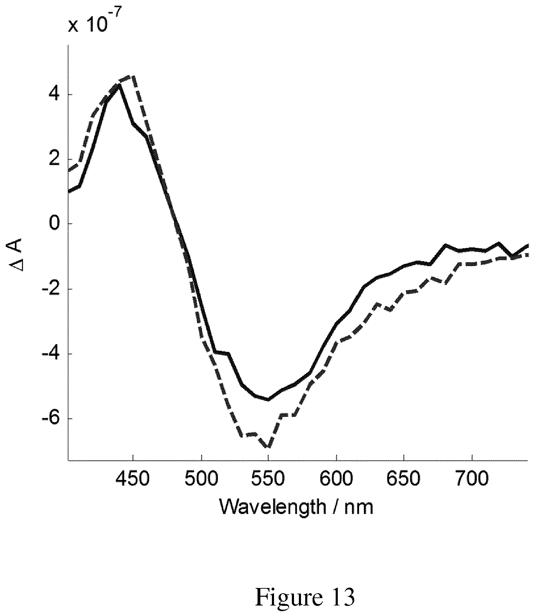

Figure 13 shows the electroabsorption spectra of D35 (solid line) and D29 (dashed line) measured using the same setup as in the photoinduced absorption measurements. A voltage was modulated at a frequency of 5.33 Hz across the samples using a function generator (HP 33120A) and ΔA was calculated from the change in transmission in phase with the modulation. The voltage offset of 0V and the voltage amplitude was 10 V.

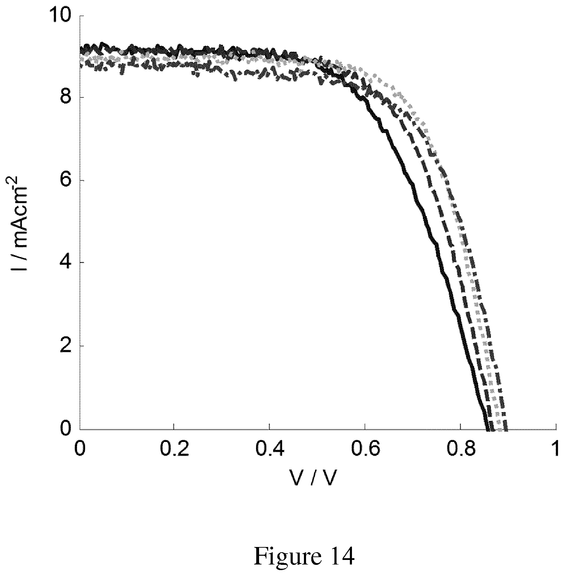

Figure 14 shows the current density versus applied potential curves under 1 sun AM1.5G illumination for DSCs sensitized with D35 using [Co(bpy)₃]^{2+/3+} with different amount of [Co(bpy)₃]³⁺ in the electrolyte. The amount of oxidized [Co(bpy)₃]³⁺ in the electrolyte was 10% (solid line), 15% (dashed line), 20 % (dotted line) and 25 % (dashed-dotted line).

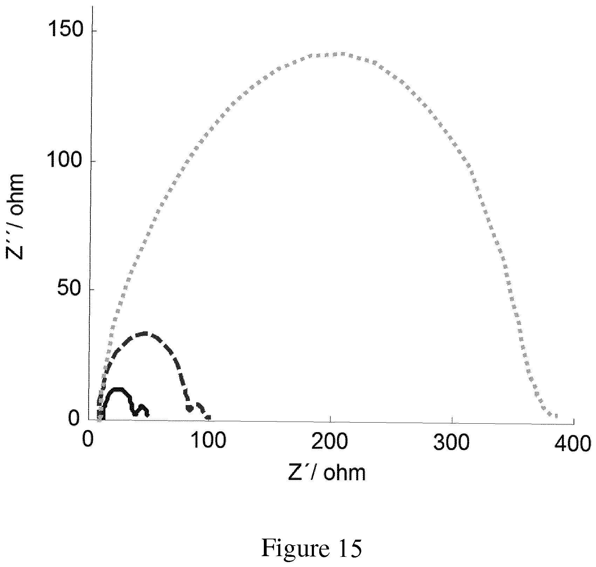

Figure 15 shows the impedance spectra measured at 0 V for sandwiched cells of two platinized counter electrodes filled with [Co(bpy)₃]^{2+/3+} (solid line), [Co(dmb)₃]^{2+/3+} (dashed line) and [Co(dtb)₃]^{2+/3+} (dotted line) based electrolytes.

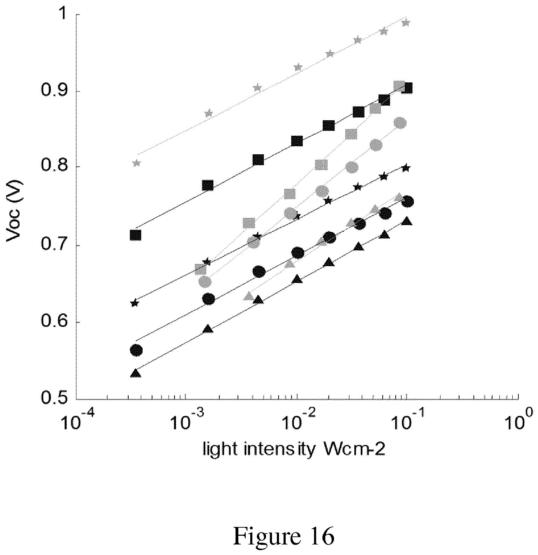

Figure 16 shows the light intensity dependence of the open circuit voltage for DSCs sensitized with D35 containing 0.1 M TBAPF₆ (black traces) or 0.1 M LiClO₄ (gray traces) using [Co(bpy)₃]^{2+/3+} (squares), [Co(dmb)₃]^{2+/3+} (circles), [Co(dtb)₃]^{2+/3+} (triangles) or iodide/triiodide (stars) based electrolytes. The slope for DSCs containing 0.1 M TBAPF₆ is 131, 115, 95 and 74 mV/decade, respectively, and for DSCs containing 0.1 M LiClO₄ about 76mV/decade for all the devices.

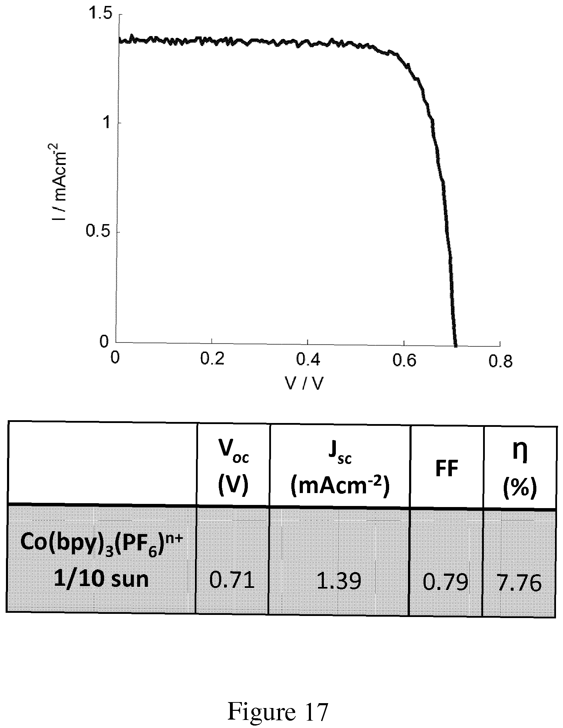

Figure 17 shows the current density versus applied potential curves under 1/10 sun AM1.5G illumination for DSCs sensitized with D35 employing a [Co(bpy)₃]^{2+/3+} based electrolyte. The electrolyte was 0.22 M Co(bpy)₃(PF₆)₂, 0.033 M Co(xxx)3(PF₆)₃, 0.1 M LiClO₄ and 0.2 M TBP in acetonitrile. The electrode thickness was 22 µm. The efficiency was measured using a 5 x 5 mm2 mask.

### DESCRIPTION OF EXAMPLE EMBODIMENTS OF THE PRESENT INVENTION

In the following description, the present invention is described with reference to a dye-sensitized solar cell comprising an organic light-absorbing dye and a one-electron transfer redox mediator.

Triphenylamine (TPA) based organic dyes have during the last years been widely examined as sensitizer in DSCs, due to the good electron donating properties of the triphenylamine unit and their potential for low cost dyes. We have herein examined the effect of the steric properties of the dye and the redox mediator on the electron lifetime and overall device performance in cobalt based DSCs. Two TPA based organic sensitizers with different electron donating substituents, D35 and D29 (Chart 1) with butoxyl chains or dimethylamine groups, respectively, were examined to investigate the effect of bulky alkoxy donor substituents in DSCs employing cobalt polypyridine redox mediators. The TPA based organic sensitizers employed herein have high extinction coefficients compared to ruthenium based dyes of about 70 000 M⁻¹cm⁻¹ and the inclusion of bulky alkoxy electron-donating substituents on the dyes have been shown elsewhere to efficiently suppress recombination in iodide/triiodide based DSCs [see Jiang, X.; Marinado, T.; Gabrielsson, E.; Hagberg, D. P.; Sun, L.; Hagfeldt, A. J. Phys. Chem. C 2010, 114, 2799]. Matching the steric bulk of the dye and the redox mediator is herein suggested to minimize recombination and mass transport problems associated with cobalt redox mediators.

The sterics of bipyridine and phenanthroline cobalt redox shuttles were varied by introducing different alkyl substituents on the polypyridine ligands. A schematic illustration of the energy diagram of a DSC sensitized with D29 and D35 employing the different cobalt redox shuttles reported herein and the chemical structure of the redox couples are shown in Figure 1a) and b), respectively. The cobalt complexes were cobalt(III/II) tris(2,2'- bipyridine), [Co(bpy)₃]^{3+/2+}, cobalt(III/II) tris(4,4'-dimethyl-2,2'- bipyridine), [Co(dmb)₃]^{3+/2+}, cobalt(III/II) tris(4,4'-di-tert-butyl-2,2'-bipyridine), [Co(dtb)₃]^{3+/2+}, and cobalt(III/II) tris(1,10-phenanthroline) [Co(phen)₃]^{3+/2+}, respectively. The results of cobalt based DSCs sensitized with TPA based organic dyes match the highest efficiencies obtained so far for iodine-free electrolytes, reaching a 6.3 % overall conversion efficiency under AM 1.5 conditions (1000 Wm⁻²) and 7.8 % at 1/10 of a sun. This is to our knowledge the first report of organic dyes in combination with cobalt redox couples in DSCs.

Current-Voltage characteristics were investigated for DSCs sensitized with the organic dyes D35 and D29 containing [Co(bpy)₃]^{3+/2+}, [Co(dmb)₃]^{3+/2+}, [Co(dtb)₃]^{3+/2+} and I-/I₃- redox shuttles to study the steric effects of the dye and the redox shuttle on the device performance and the resulting current density versus potential curves are shown in Figure 2a) and b), respectively. The photovoltaic performance of cobalt polypyridine redox mediators is superior to that of the iodide/triiodide redox shuttle for thin film DSCs sensitized with triphenylamine-based organic sensitizers. Despite the enhanced spectral response of D29 in the red region of visible light as seen in Figure 10 the efficiency is higher for DSCs sensitized with D35. The higher efficiency yield with D35 is a result of decreased dark current densities as seen in Figure 11 as the butoxyl groups introduced on D35 prevents the surface of the TiO₂ from the oxidized species in the electrolyte. The open circuit voltage (Voc) for DSCs sensitized with D35 is remarkably high for organic dyes since the recombination is significantly slowed down as a result of the insulating effect of the bulky alkoxy groups.

Surprisingly [Co(bpy)₃]^{3+/2+} in combination with D35 yields the highest efficiency of 4.89 % among the different redox mediators employed. [Co(bpy)₃]^{3+/2+} has been shown elsewhere to suffer from fast recombination yielding a modest efficiency of 1.3 % using ALD coatings to passivate the TiO₂ surface in combination with ruthenium based dyes [see Klahr, B. M.; Hamann, T. W. J. Phys. Chem. C 2009, 113, 14040]. The high Voc of 0.88 V for D35 based DSCs employing [Co(bpy)₃]^{3+/2+} is notably and in contrary to the result by many other groups where the use of one electron redox couples with a more positive redox potential than the iodide/triiodide redox shuttle have been showed to lead to increased dark current densities. [Co(dtb)₃]^{3+/2+} has earlier been the choice of redox couple by many groups as the steric tert-butyl groups has been found to slow down the recombination rate. In agreement with earlier reports the fill factor is, however, poor using [Co(dtb)₃]^{3+/2+}, attributed to mass transport problems of the electrolyte.

The Incident-photon-to-current conversion efficiency (IPCE) for the same series of DSCs as discussed above is shown in Figure 2c) and d), respectively. The IPCE for DSCs sensitized with D35 is about 90 % for all the different redox mediators employed and not much affected by the sterics of the cobalt complexes. The IPCE spectra is broader in the spectral range between 360 nm - 460 nm for DSCs employing cobalt redox mediators compared to the I⁻/I₃⁻ redox couple due to competitive light absorption by triiodide. The loss in photocurrent due to absorption of triidodie at lower wavelengths is clearly observed when illumination the cell from the counter electrode side as seen in Figure 12. This illustrates one of the benefits of using the cobalt redox couples in DSCs and may partly explain the lower currents observed in the current-voltage plots of DSCs using iodide/triiodide compared to cobalt redox mediators.

The best efficiency yield at 1 sun for DSCs sensitized with D29 of 2.57 % is achieved using a [Co(dmb)₃]^{3+/2+} based electrolyte, even though the Voc in agreement with the results of the D35 dye is higher using [Co(bpy)₃]^{3+/2+}. The IPCE for D29 based DSCs increases, however, with the sterics of the cobalt complexes and the best IPCE of about 70 % is found for DSCs employing [Co(dtb)₃]^{3+/2+}. The lower efficiency using [Co(dtb)₃]^{3+/2} at higher light intensities is most likely a result of slow mass transport of the electrolyte, since mass transport limitations are not thought to influence the IPCE at the lower light intensities used under monochromatic illumination. The fill factor is interestingly better for DSCs based on D29 compared to D35, suggesting that the steric bulk of D35 slightly slows down mass transport of cobalt bipyridyl complexes through the mesoporous TiO₂ film. The lower IPCE values with the less steric bulk of the cobalt complexes for D29 based DSCs can be a result of a lower driving force for regeneration and / or fast recombination kinetics, and the different aspects will be further considered below.

Recombination kinetics were investigated using small amplitude modulation technique to study the steric effects of the dyes and the redox mediators on the recombination in order to understand the high efficiency yield of D35 based DSCs employing [Co(bpy)₃]^{3+/2+}. The electron lifetime as a function of extracted charge for DSCs sensitized with D35 and D29 employing the three different cobalt bipyridyl redox mediators and I⁻/I₃⁻ is shown in Figure 2e) and f), respectively. Recombination is slower for DSCs sensitized with D35 compared to D29 as a result of the insulating effect of the butoxy groups introduced on D35 as discussed above. The electron lifetime increases as the IPCE increases with the steric bulk of the redox mediator for DSCs sensitized with D29. This agrees with previous results from Klahr et al.12 where the steric groups on [Co(dtb)₃]^{3+/2+} were found to act as insulating spacers, decreasing the electronic coupling and thereby fast recombination processes in DSCs employing cobalt bipyridyl redox mediators. For D35, however, the insulating effect of the alkoxy chains efficiently hinders recombination and the electron lifetime is not as much affected by the steric groups of the cobalt complexes. The slightly lower electron lifetime using [Co(bpy)₃]^{3+/2+} does not seem to affect the photovoltaic performance of this redox mediator and fast recombination kinetics is therefore not anticipated a limiting factor in cobalt based DSCs sensitized with D35. The electron lifetime is interestingly longer for both dyes employing iodide/triiodide in the electrolyte, even though the efficiency is lower with this redox mediator.

The redox potential of the cobalt complexes were varied to investigate the dependence of the redox shuttle on the Voc and the resulting current-voltage characteristics for DSCs sensitized with D35 employing [Co(bpy)₃]^{3+/2+}, [Co(dmb)₃]^{3+/2+} and [Co(phen)₃]^{3+/2+} based electrolytes are shown in Figure 3. The redox potential of the cobalt polypyridine complexes employed herein are shown in Figure 1 and are 0.62 V vs. NHE for [Co(phen)₃]^{3+/2+}, 0.56 V vs. NHE for [Co(bpy)₃]^{3+/2+} and 0.43 V vs. NHE for [Co(dmb)₃]^{3+/2+} and [Co(dtb)3]^{3+/2+}, respectively. The Voc increases with the Nernst potential of the redox shuttles and the highest Voc of 0.92 V is obtained using [Co(phen)₃]^{3+/2+} as a redox couple. DeVries et al. [see DeVries, M. J.; Pellin, M. J.; Hupp, J. T. Langmuir 2010] showed for a series of derivatives of [Co(1,10-phenanthroline)₃] complexes that the Voc increased as the formal potential of the redox couple became more positive. They found that the open circuit quasi-Fermi level became less negative with increasing redox potential and that the interception of photoinjected electrons with Co(III) was faster as the driving force for recombination increased, indicating Marcus normal-region behavior. This agrees with the result obtained herein but the recombination is not only suggested to depend on the driving force for recombination, but also on the sterics of the redox mediators as discussed above. [Co(phen)₃]^{3+/2+} was despite its better redox potential not used further for the optimization of the photovoltaic performance in this paper because of its lower solubility in acetonitrile. The redox potential of [Co(phen)₃]^{3+/2+} can, however, be increased by substituting electron withdrawing groups on the 1,10-phenanthroline unit and to increase the Voc by tuning the Nernst potential of this redox shuttle. As observed by DeVries et al. [see DeVries, M. J.; Pellin, M. J.; Hupp, J. T. Langmuir 2010] the current is not much affected by the redox potential of the cobalt complexes, indicating that insufficient driving force for regeneration is not a limiting factor in the cobalt based DSCs employed herein. Regeneration limitation in cobalt based DSCs will be further discussed below.

The regeneration of the dyes by the cobalt complexes was investigated with photoinduced absorption spectroscopy performed under operation conditions of DSCs. The PIA spectra of D35 and D29 employing the three different cobalt bipyridyl redox mediators reported herein and iodide/triiodide are shown in Figure 4a) and b), respectively. In absence of a redox mediator, a bleach is found at 520 nm for D35 and 540 nm for D29, respectively, and an increase in absorbance in the near infrared. The latter can be attributed to the oxidized dye, and to a lesser extent, electron in TiO₂. The bleach is attributed both to ground-state bleach of the oxidized dye, as well as to Stark shifts that occurs due to a local change of the electrical field across the dye molecules, caused by the photoinjected electrons. When the electrolyte is added the oxidized features from the dye in the near infrared disappears indicating that the redox mediators regenerate the dye and a broad absorption due to accumulated electrons in TiO₂ can be seen. A bleach at about 520 nm persists, which is caused by the Stark effect. The electroabsorption spectra of D35 and D29 shown in Figure 13 verify that the observed bleaches are caused by a change in the absorbance spectra of the dye by a local electric field. No time constants for the regeneration were measured herein, but the lifetime of Ru(III) in the presence of [Co(dtb)₃]^{3+/2+} has been reported elsewhere to be about 400 ns. 14

If the cobalt complexes were limited by slow regeneration the regeneration rate should increase with increasing concentration of Co(II). Klahr et al. [see Klahr, B. M.; Hamann, T. W. J. Phys. Chem. C 2009, 113, 14040] reported no improvement in the cell performance by increasing the concentration of Co(II) and suggested that the cobalt complexes were not limited to a significant degree by slow regeneration kinetics. The fill factor was, however, observed herein to increase with increasing cobalt concentration (data not shown), indicating that cobalt bipyridyl complexes are to some extent limited by regeneration. The high IPCE values for DSCs sensitized with D35 suggests on the other hand that the regeneration efficiency is high, pointing towards that it is slow mass transport of the cobalt complexes that slows down the regeneration since mass transport limitations are not thought to influence the IPCE. The lower IPCE value for DSCs sensitized with D29 was therefore not attributed to a lower driving force for regeneration, but rather to fast recombination kinetics.

The effect of mass transport issues in DSCs employing cobalt bipyridyl redox mediators were investigated by monitoring photocurrent transients using large modulation (on / off) of the incident light. Photocurrent transients measured at 1 sun for DSCs sensitized with D35 and D29 using the cobalt bipyridyl redox mediators reported herein are shown in Figure 5a) and b), respectively. As reported elsewhere, a maximum in photocurrent is observed when the light is switched on, followed by a decrease in photocurrent, eventually reaching a constant value. The sustainable current has been shown to increase with increasing concentration of Co(III) in the electrolyte suggesting that it is the diffusion of Co(III) to the counter electrode that limits the cell performance [see Nelson, J. J.; Amick, T. J.; Elliott, C. M. J. Phys. Chem. C 2008, 112, 18255]. The cell performance, and in particular the fill factor was found in our lab to increase with increasing concentration of Co(III) as seen in Figure 14, which agrees with that slow mass transport of Co(III) to the counter electrode limits the cell performance. The current spike in the photocurrent transients increases in the order [Co(dtb)₃]^{3+/2+} > [Co(dmb)₃]^{3+/2+} > [Co(bpy)₃]^{3+/2+}, indicating that mass transport problems increases with the sterics of the redox mediator. At lower light intensities mass transport is no longer a problem and no current spike is observed (data not shown). The maximum current spike is the same for DSCs sensitized D35 for the different cobalt redox mediators employed, indicating that the lower current obtained using [Co(dtb)₃]^{3+/2+} and [Co(dmb)₃]^{3+/2+} is as a result of slower mass transport of these complexes. For D29, however, the maximum spike current increases with the steric bulk of the cobalt complexes suggesting that the current also depends on recombination with photoinjected electrons with the oxidized form of the redox mediator, as discussed above.

The diffusion coefficients of the cobalt bipyridyl redox mediators were determined from the diffusion limiting current measured by slow scan cyclic voltammetry to 5.25 × 10-6 cm²s⁻¹ for [Co(dtb)₃]^{3+/2+}, 7.74 x 10-6 cm^{2s-1} for [Co(dmb)₃]^{3+/2+} and 9.12 × 10-6 cm^{2s-1} for [Co(bpy)₃]^{3+/2+} in acetonitrile. The diffusion is substantially slower for the cobalt bipyridyl redox mediators than for I₃⁻, which has a diffusion coefficient of 18 x 10-6 cm²s⁻¹.13 The diffusion of [Co(bpy)₃]^{3+/2+} seems, however, to be fast enough in a 6 µm thick DSC, as the current spike in the photocurrent transient is almost not visible. The short circuit current is also shown in Figure 6a) to be linear with light intensity for [Co(bpy)₃]^{3+/2+}, but to deviate from linearity at higher light intensity for [Co(dmb)₃]^{3+/2+} and [Co(dtb)₃]^{3+/2+} due to mass transport problems of the bigger cobalt complexes. The high efficiency yield for DSCs sensitized with D35 using [Co(bpy)₃]^{3+/2+} can therefore be explained by that the recombination is efficiently slowed down by using a dye with bulky alkoxy groups and that mass transport problems are avoided by using a cobalt redox mediator with a less steric bulk.

The resistance at platinized counter electrode measured with impedance spectroscopy seen in Figure 15 and the irreversibility of the cobalt complexes also increases in the order [Co(dtb)₃]^{3+/2+} > [Co(dmb)₃]^{3+/2+} > [Co(bpy)₃]^{3+/2+}. Cobalt complexes containing alkyl substituents in the 4 and 4' or equivalent positions have been shown elsewhere to be surface sensitive showing irreversible behavior on platinized electrodes [see Sapp, S. A.; Elliott, C. M.; Contado, C.; Caramori, S.; Bignozzi, C. A. J. Am. Chem. Soc. 2002, 124, 11215]. The lower resistance at the counter electrode for [Co(bpy)₃]^{3+/2+} further shows the advantages of employing this redox mediator in DSCs. Initial result have been shown promising of changing the material of the catalyst on the counter electrode to a less expensive one.

The light intensity dependence on the open circuit potential for DSCs sensitized with D35 employing the three different cobalt bipyridyl redox mediators and iodide/triiodide is shown in Figure 6b). Interestingly the slope in the Voc versus light intensity plot is about 76 mV/decade for all different redox mediators. If recombination occurs solely via the conduction band of the TiO₂ and the reaction order is first in electron kinetics a slope of 59 mV/decade at 298 K is expected. Many groups have recently found that the recombination is non-linear but the origin of the non-linear recombination still needs to be established in order to improve the understanding of the operation of the devices [see e.g. Bisquert, J.; Mora-Seró, I. J. Phys. Chem. Lett. 2009, 1, 450; Villanueva-Cab, J.; Wang, H.; Oskam, G.; Peter, L. M. J. Phys. Chem. Lett. 2010, 1, 748]. The "ideality" and the linearity of the semilogarithmic plots of the photovoltage versus incident photon flux was recently shown by Jennings et Wang [see Jennings, J. R.; Wang, Q. J. Phys. Chem. C 2009, 114, 1715] to increase with increasing Li+ concentration attributed to a downward shift in the TiO₂ energy levels as a result of specific adsorption of Li+ at the TiO₂ surface. The ideality of the cell was found to increase with increasing Li+ concentration as the overlap between occupied donor states (conduction band and surface states) in the TiO₂ with electron acceptor states in the electrolyte increased. For the Co-mediator-based DSCs investigated here the slope in the Voc vs. light intensity plots also changes with addition of Li+ in the electrolyte. The slope for DSCs containing 0.1 M TBAPF₆ in the electrolyte increases, however, up to 131 mV/decade as the electron lifetime decreases with the less steric bulk of the cobalt complexes as seen in Figure 16. The results obtained herein suggest that the non-linear recombination does not depend on the nature of the redox mediators employed upon the addition of Li+ in the electrolyte and it is therefore suggested that the nonlinear recombination is a result of electron transfer via surface states and/or a shift in the conduction band energy under illumination. Nakade et al. [Nakade, S.; Makimoto, Y.; Kubo, W.; Kitamura, T.; Wada, Y.; Yanagida, S. J. Phys. Chem. B 2005, 109, 3488] showed that recombination in DSCs employing cobalt redox mediator was slowed down by the addition of Li+ and attributed the effect to a decrease in local concentration of Co(III) caused by repulsion of adsorbed Li cations. Recombination via surface states may therefore be avoided by the addition of Li+ in the electrolyte, but can become more dominant when less-adsorptive cations like TBA+ is used. In the case of addition of TBA+ in the electrolyte the reaction order also depends on the nature of the redox couple employed since electron transfer via surface state to the oxidized redox mediator may become more significant.

Figure 7 shows the effect of varying film thickness on the transport and electron lifetime in DSCs sensitized with D35 using a [Co(bpy)₃]^{3+/2+} based electrolyte. The electron lifetime decreases and the transport time increases, i.e. the transport slows down, with increasing thickness of the TiO₂. Electron transport is suggested to be driven by diffusion and has been shown elsewhere to increase with the film thickness in DSCs [see Nissfolk, J.; Fredin, K.; Simiyu, J.; Häggman, L.; Hagfeldt, A.; Boschloo, G. J. Electroanal. Chem. 2010, *In Press, Corrected Proof*]. Recombination of photoinjected electrons with the oxidized redox species is in addition slowed down in thin film DSCs since the electron transport is faster, resulting in lower electron densities in the film which prevents recombination losses. Figure 8 shows the effect of varying the TiO₂ film thickness on photocurrent transients for DSCs sensitized with D35 employing [Co(bpy)₃]^{3+/2+} in the electrolyte. The photocurrent transients were normalized with respect to the steady state current in order to illustrate the increase in the current spike with increasing film thickness as the light is switched on. In DSCs with thicker TiO₂ films the current is clearly limited by mass transport problems through the mesoporous TiO₂ film. The cell performance was not much affected by varying the thickness of the surlyn spacer, suggesting that it is the diffusion through the mesoporous TiO₂ network rather than in the bulk electrolyte that limits the performance of DSCs employing cobalt polypyridine redox mediators. The diffusion of [Co(dtb)₃]ⁿ⁺ through mesoporous titania films was measured by Nelson et al. [Nelson, J. J.; Amick, T. J.; Elliott, C. M. J. Phys. Chem. C 2008, 112, 18255] to be about 1 order of magnitude slower than for I₃⁻. Organic dyes with high exctinction coefficients can, however, be used to build thin film DSCs in order to overcome mass transport and recombination limitations related with cobalt redox mediators.

The current-voltage characteristics was optimized for DSCs sensitized with D35 employing [Co(bpy)₃]^{3+/2+} and iodide/triiodide electrolyte and the best obtained efficiencies are shown in Figure 9 and Table 1. Although mass transport problems were shown to be avoided in thin film DSCs employing [Co(bpy)₃]^{3+/2+}, the best efficiency yield was still obtained for thicker films because of increased light harvesting efficiency, i.e. two layers of TiO₂ and one scattering layer to a total thickness of 15 µm. The best efficiency of 6.71 % for [Co(bpy)₃]^{3+/2+} and of 5.53 % for iodide/triiodide, respectively, measured at 1 sun AM1.5G illumination is shown in Figure 9a). It should be noted that the efficiency reported above was measured using a 6 x 6 mm2 mask, following the recommendation by Ito et al. [see Ito, S.; Nazeeruddin, K.; Liska, P.; Comte, P.; Charvet, R.; Péchy, P.; Jirousek, M.; Kay, A.; Zakeeruddin, S. M.; Grätzel, M. Prog. Photovoltaics Res. Appl. 2006, 14, 589] and that the efficiency decreased to 6.27 % for [Co(bpy)₃]^{3+/2+} and 5.36 % for iodide/triiodide by using a mask that was smaller than the film area. The efficiency of DSCs sensitized with D35 employing cobalt redox mediators is superior to that obtained by other groups working with cobalt based DSCs using ruthenium based sensitizers and shows the advantages of using organic dyes in cobalt based DSCs. The best efficiency obtained at 1/10 of a sun was 7.76 % using electrodes with three layers of TiO₂ and a lower concentration of cobalt in the electrolyte than that used for the optimized result reported here as seen in Figure 17. It can be noted that the efficiency increases when the solar cells are heated under the solar simulator since the diffusion of the cobalt complexes is faster at higher temperatures. Liberatore et al. [see Liberatore, M.; Petrocco, A.; Caprioli, F.; La Mesa, C.; Decker, F.; Bignozzi, C. A. Electrochimica Acta 2010, 55, 4025] found that the standard rate electron coefficient for [Co(dtb)₃]ⁿ⁺ in methoxypropionitrile increased more than 6 times and the ionic diffusion coefficient more than 3 times at 80°C.28

DSCs employing cobalt redox mediators are promising for indoor applications as the efficiency and the voltage is kept high even at low light intensities. As shown in the current-voltage characteristics in Figure 9b) is the voltage about 700 mV at a light intensity of 250 lux for D35 based DSCs employing [Co(bpy)₃]^{3+/2+}. For comparison the best voltage at low light intensities for modules with the ruthenium based sensitizer, N719, employing the iodide/triiodide redox couple as well as amorphous silicon modules was measured by Burnside et al.29 to 539 mV/element and 677 mV/element at 250 lux, respectively. The voltage for sandwiched DSCs sensitized with N719 employing iodide/triiodide was shown in the same study to be about 370 mV at a light intensity of 100 lux and is substantially lower than the voltage obtained herein of above 600 mV at the same light intensity (data not shown). Modules of D35 based DSCs using cobalt redox mediators have a great potential to exceed the efficiency of the above reported devices and the stability of the devices can be extended by using the less corrosive redox couple.

The Voc and the electron lifetime are interestingly about the same for the optimized DSCs reported herein with addition of a large amount of TBP in the electrolyte. The Voc increases upon the addition of TBP in the electrolyte for both DSCs employing iodide/triiodide or cobalt based redox mediators, but the mechanism of TBP appears to be different in the solar cells. Nakade et al. [see Nakade, S.; Makimoto, Y.; Kubo, W.; Kitamura, T.; Wada, Y.; Yanagida, S. J. Phys. Chem. B 2005, 109, 3488; Nakade, S.; Kanzaki, T.; Kubo, W.; Kitamura, T.; Wada, Y.; Yanagida, S. J. Phys. Chem. B 2005, 109, 3480] investigated the effect of TBP in DSCs employing iodide/triiodide and cobalt based redox mediators and found no significant shift in electron lifetime upon addition of TBP in the electrolyte for iodide/triiodide based DSCs, but an increase in electron lifetime in cobalt based DSCs. The increase in Voc in DSCs using the iodide/triiodide redox shuttle was, however, attributed to a negative shift in the conduction band as a result of a decreased amount of adsorbed Li cations at the TiO₂ surface. A similar trend was found herein, but a small negative shift in conduction band was also observed for DSCs using cobalt redox complexes.

Figure F1 shows the structural motif of the TAA-based dyes for use in DSCs with cobalt-based electrolytes. The triarylamine core is part of the electron rich donor side of the molecule, which is electronically linked to the acceptor and anchor group A through a conjugated π-system. Ar and Ar' are electron donating aromatic substituents, typically substituted phenyls or biphenyls, or additional linker-acceptor/anchoring groups.

The substituents Ar and Ar' may be identical so that Ar=Ar', or diverse. Electron donating aromatic substituents include phenyl, thiophene, furan, naphthyl-derivatives and other polycyclic aromatic hydrocarbons, fused heterocyclic systems and their corresponding oligomeric variants. They may be substituted by aliphatic groups in order to control the steric bulk of the molecule. Oligomers may be rigidified by ortho-linkage, effectively making them for example fluorenes, carbazoles or siloles.

**A** is an electron withdrawing group that chemically and electronically connects the dye to the semiconductor surface. Modification of the anchoring group is typically used to tune the electronic coupling between the dye and the semiconductor. Successful anchoring groups include carboxylic acid functions such as cyanoacrylic acid and rhodanine-3-acetic acid. It may also be possible to use a phosphorous or sulfur based anchoring group, for example in the form of a phosphonate or sulfonate.

**π** is a series of one or more conjugated units which electronically link the donor and acceptor part of the dye molecule. These central units may consist of a combination of 5 or 6-membered unsaturated (hetero)cyclic units containing up to four heteroatoms from group 14-16 of the periodic table per ring (primarily phenyl, thiophene, furan, pyrrole, thiazole and oxazole) or their fused and polycyclic variants (such as thieno[3,2-*b*]thiophene, dithieno[3,2-*b*:2',3'-*d*]thiophene, phenothiazine, phenoxazine, 4H-silolo[3,2-*b*:4,5-*b*']dithiophene and carbazole). These central, π-conjugated units will be further functionalized to tune the chemical and physical properties of the sensitizer. These straight chain or cyclic substituents around the periphery of the central **π**-system may be fully saturated, such as in 3,4-ethylenedioxythiophene. The aromatic units of the linker may also be spaced by olefinic segments, provided that the conjugation between the donor and acceptor is not disrupted.

The key to the success of our strategy is the exploitation of the high extinction coefficient of the organic dye in combination with a thin TiO₂ electrode. To increase the extinction coefficient of the dye further, it is desirable to reduce the dihedral angles between the conjugated units. This can be achieved by using for example 3,4-ethylenedioxythiophene units in donor or linker positions, by fusing cyclic units of the system or by linking two cycles in ortho-position, effectively creating an additional 5-membered ring, as illustrated in Figure F2, where the linking atom X can be any group 14-15 element, but typically C, Si or N. In addition, simultaneously increase the extinction coefficient and broaden the absorption spectrum of the dye further by increasing the length of the π-system. Some example dyes using this concept are shown in Figure F3. A synthetic route for D35EDOT can be seen in Figure F4. Going from D35 to D35EDOT, broader and stronger light absorption is expected, while the oxidation potential of the dye is lowered by 0.2 V, as indicated by quantum chemical calculations. The absorption is expected to be broadened even further by going to D35E, but at the cost of a lower extinction coefficient.

A similarly crucial property of the dye when used in combination with Co-based redox couples is the steric bulk, which can be controlled by the number and composition of the aliphatic chains attached on Ar, Ar' or **π**. Hydrogens on the dye periphery can substituted for cyclic or acyclic, straight or branched aliphatic groups, such as alkyl, alkoxy or ethylene glycol groups, provided that the π-conjugation is maintained. Simultaneously, the electronic effect of these substituents will be used to tune the energy levels of the dye; for example, alkoxy groups have π-electron donating properties in aromatic systems. Furthermore, bulky substituents can be introduced on element X (see Figure F2). When X=Si or N, a bulky group also serves to protect the heteroatom.

Since our strategy to tailor the dye to the properties of the electrolyte has opened new avenues to exploit the diverse array of cobalt polypyridyl complexes available, we can shift the redox potential of the shuttle in the positive direction on an electrochemical scale, by tuning the coordination sphere of the complexes. The redox potential can be tuned by substituting different electron donating and electron withdrawing groups around the periphery of bidentate or tridentate polypyridine ligands, constisting of fused 5- or 6-membered *N*-heterocycles. The corresponding complexes included in the optimization of these cobalt-based DSCs incorporating triarylamine-based organic sensitizers are cobalt(II) bipyridine, phenathroline, terpyridine and 2,6-di(quinolin-8-yl-pyridine) complexes. The redox potential of the complexes can be tuned varying the number and type of substituents around the ligands as shown in Figure F5.

Typical substituents for R₁₋₁₀ include hydrogen, hydroxyl, alkyl, cycloalkyl, aryl, haloalkyl, heteroaryl, carboxyl, halogen, oxo, nitro, nitrile, amine or amide functions. The corresponding substituents R₁₋₁₀ around the bidentate and tridentate polypyridine ligands do not have to be identical.

In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage.

The advantages of the dye-sensitized solar cell according to the present invention have been demonstrated in experiments.

### EXAMPLES

### Experimental methods

All chemicals were purchased from Sigma Aldrich unless otherwise noted.

**Syntheses of cobalt complexes.** The cobalt complexes [Co(bpy)3(PF6)2]2+, [Co(dmb)₃(PF₆)₂]²⁺, [Co(dtb)₃(PF₆)₂]²⁺ and [Co(phen)₃(PF₆)₂]²⁺ were synthesized as described elsewhere (see Sapp, S. A.; Elliott, C. M.; Contado, C.; Caramori, S.; Bignozzi, C. A. J. Am. Chem. Soc. 2002, 124, 11215; Klahr, B. M.; Hamann, T. W. J. Phys. Chem. C 2009, 113, 14040). Briefly, 1 equiv of CoCl₂. 6H₂O and 3.3 equiv of the polypyridine ligand were dissolved in a minimal amount of methanol (Merck) and the solution was stirred at reflux for 2 h. An excess of ammonium hexafluorophosphate was then added to the solution to precipitate the compound that was filtered, washed with methanol and ethanol, dried under vaccum and used without further purification.
Oxidation of the cobalt complexes was performed by adding a slight excess of NOBF₄ to an acetonitrile solution of the cobalt complex and then by removing the acetonitrile solution by rotary evaporation. The complex was then redissolved in acetonitrile and a large amount of NH₄PF₆ was added to the solution to remove the BF₄- anion. The final product was precipitated with diethylether, filtered, dried under vaccum and used without further purification.

**Solar cell preparation.** Working electrodes with titanium tetrachloride pre- and post-treatment were prepared on fluorine-doped tin oxide (FTO) glass (TEC15, Pilkington). Mesoporous TiO₂ films of different thicknesses were prepared with an area of 0.25 cm² by screen printing colloidal TiO₂ paste (Dyesol DSL 30 NRD-T). For some cells a scattering layer (PST-400C, JGC Catalysts and Chemical LTD) was deposited on top of the mesoporous TiO₂ film. The electrodes were sintered at 500°C for 30 minutes. The thickness of the films was about 5.6 µm unless otherwise noted as measured using a profilometer (Veeco Dektak 3). Hot TiO₂ films were immersed in a dye bath containing 0.2 mM D35 in ethanol or 0.2 mM D29 in acetonitrile and left overnight. The films were then rinsed in ethanol to remove excess dye. Solar cells were assembled with a thermally platinized counter electrode (TEC8) using a 30 µm thick thermoplastic Surlyn frame. An electrolyte was then introduced through two holes drilled in the counter electrode and the cell was sealed with thermoplastic Surlyn covers. Unless otherwise noted the electrolyte consisted of 0.22 M Co(xxx)₃(PF6)₂, 0.033 M Co(xxx)₃(PF₆)₃, 0.1 M LiClO₄ and 0.2 M 4-tert butylpyridine (TBP) in acetonitrile, where xxx ascribe the different polypyridine ligands, respectively. For comparison DSCs were prepared using 0.6 M tertbutylammonium iodide, 0.1 M LiI, 0.05 M I₂ and 0.2 M TBP in acetonitrile.

**Solar cell characterization.** Current-Voltage (IV) characteristics were measured under 1000 Wm-2 and 100 Wm-2 AM 1.5 G illumination using a Newport solar simulator (model 91160) and a Keithley 2400 source/meter. Photovoltaic measurements at low light intensities were performed using an OSRAM energy saving lamp 8 W, as a light source. The cells were measured at a light intensity of 250 lux, as measured using a luxmeter. Incident photon to current conversion efficiency (IPCE) spectra were recorded using a computer-controlled setup consisting of a xenon light source (Spectral Products ASB-XE-175), a monochromator (Spectral Products CM110) and a potentiostat (EG&G PAR 273), calibrated using a certified reference solar cell (Fraunhofer ISE). Electron lifetime, transport times and extracted charge measurements were perfomed using a white LED (Luxeon Star 1 W) as the light source. Voltage and current traces were recorded with a 16-bit resolution digital acquisition board (National Instruments) in combination with a current amplifier (Stanford Research Systems SR570) and a custom made system using electromagnetic switches. Transport and lifetimes were determined by monitoring photocurrent and photovoltage transients at different light intensities upon applying a small square wave modulation to the base light intensity. The photocurrent and photovoltaic responses are fitted using first-order kinetics to obtain time constants. Extracted charge measurements were performed by illuminating the cell for 10 s under open circuit conditions and then by turning the lamp off to let the voltage to decay to a voltage V. The cell was then short circuited and the current was measured under 0.1 s and integrated to obtain Qoc (V).

**Photoinduced Absorption Spectroscopy (PIA). PIA** measurements were performed using the same setup as described elsewhere.21 A square wave modulated blue LED (Luxeon Star 1 W, Royal Blue, 460 nm) used for excitation was superimposed on a white probe light provided by a 20 W tungsten-halogen lamp. The transmitted probe light was focused onto a monochromator (Acton Research Corporation SP-150) and detected using a UV-enhanced Si photodiode, connected to a lock-in amplifier (Stanford Research Systems model SR830) via a current amplifier (Stanford Research Systems model SR570). The intensity of the probe light was about 1/10 of a sun and the intensity of the excitation LED was about 8 mW cm⁻². The modulation frequency was 9.33 Hz.

**Electrochemical measurements.** Cyclic Voltammetry was performed on a CH Instruments 660 potentiostat using a three-electrode setup. For the diffusion measurements a 20 µm platina microelectrode was used as the working electrode, a glassy carbon as counter electrode and an Ag/AgNO₃ as reference electrode. The reference electrode was calibrated versus ferrocene. The electrolyte solution was 15 mM Co(xxx)₃(PF₆)₂ and 0.1 M TBAPF₆ in acetonitrile. Impedance measurements were performed on an Ivium potentiostat using a two electrode setup consisting of two platinized FTO electrodes.

## Claims

1. A dye-sensitized solar cell comprising a mesoporous semi-conductor sensitized with a light-absorbing dye, a counter electrode, and an electrolyte comprising a redox mediator, wherein an organic light-absorbing dye is used in combination with a one-electron transfer redox mediator,
wherein said organic dye comprises steric groups that suppress recombination between electrons in the semi-conductor and acceptor species in said electrolyte, and **characterized in that**
said organic dye has the following structure: 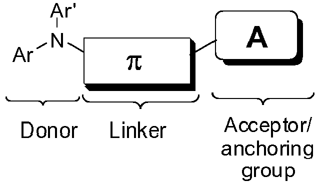 wherein the donor comprises a triarylamine group having electron donating aromatic substituents Ar and Ar', wherein A is an electron withdrawing group, and wherein π is a series of one or more conjugated units which electronically links the donor and acceptor parts of the dye molecules; and
wherein said organic dye comprises a triphenylamine.

2. The dye-sensitized solar cell according to claim 1, wherein said Ar and Ar' are any one of phenyl, thiophene, furan, naphthyl-derivatives and other polycyclic aromatic hydrocarbons, fused heterocyclic systems and their corresponding oligomeric variants.

3. The dye-sensitized solar cell according to any one of the preceding claims, wherein A comprises a carboxylic acid functions such as cyanoacrylic acid and rhodanine-3-acetic acid, or a phosphorous or sulfur based anchoring group, such as in the form of a phosphonate or sulfonate.

4. The dye-sensitized solar cell according to any one of the preceding claims, wherein **π** comprises a combination of 5 or 6-membered unsaturated (hetero)cyclic units containing up to four heteroatoms from group 14-16 of the periodic table per ring, primarily phenyl, thiophene, furan, pyrrole, thiazole and oxazole, or their fused and polycyclic variants such as thieno[3,2-*b*]thiophene, dithieno[3,2-*b*:2',3'-*d*]thiophene, phenothiazine, phenoxazine, 4H-silolo[3,2-*b*:4,5-*b*']dithiophene and carbazole.

5. The dye-sensitized solar cell according to any one of the preceding claims, wherein said organic dye is D29 having the following formula: 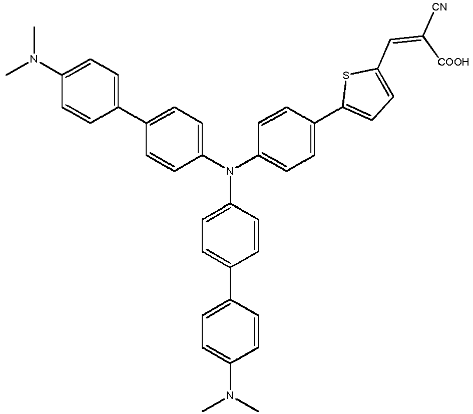 or D35 having the following formula:

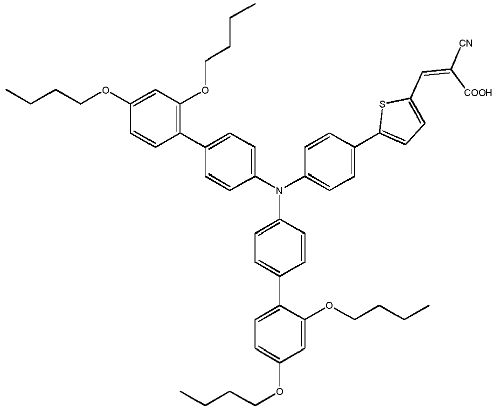

6. The dye-sensitized solar cell according to any one of the preceding claims, **characterized in that** said organic dye has an extinction coefficient of at least 70000 M⁻¹cm⁻¹.

7. The dye-sensitized solar cell according to any one of the preceding claims, **characterized in that** the one-electron transfer redox mediator is a cobalt complex with a central cobalt atom with organic ligands.

8. The dye-sensitized solar cell according to any one of the preceding claims, **characterized in that** said one-electron transfer redox mediator is a cobalt polypyridine complex.

9. The dye-sensitized solar cell according to any one of the preceding claims, **characterized in that** the material of said counter electrode comprises platinum.

10. The dye-sensitized solar cell according to claim 1, **characterized in that** the material of said counter electrode comprises carbon.

11. The dye-sensitized solar cell according to claim 1, **characterized in that** said mesoporous semiconductor comprises TiO₂.

## Patentansprüche

1. Farbstoffsensibilisierte Solarelle, umfassend einen mesoporösen Halbleiter, welcher mit einem Licht absorbierenden Farbstoff sensibilisiert ist, eine Gegenelektrode und einen Elektrolyten, welcher einen Redox-Mediator umfasst, wobei
ein organischer Licht absorbierender Farbstoff in Verbindung mit einem Einelektronenaustausch-Redox-Mediator verwendet wird,
wobei der organische Farbstoff sterische Gruppen umfasst, welche eine Rekombination zwischen Elektronen in dem Halbleiter und einer Akzeptor-Spezies in dem Elektrolyten unterdrücken, und
**dadurch gekennzeichnet ist, dass**
der organische Farbstoff die folgende Struktur aufweist: 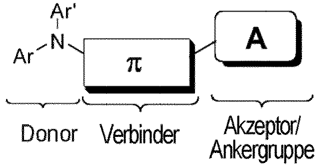 wobei der Donor eine Triarylamin-Gruppe umfasst, welche elektronenabgebende aromatische Substituenten Ar und Ar' aufweist, wobei A eine elektronenziehende Gruppe ist und wobei n eine Reihe von einer oder mehreren konjugierten Einheiten ist, welche die Donor- und Akzeptor-Teile der Farbstoffmoleküle elektronisch verbinden; und
wobei der organische Farbstoff ein Triphenylamin umfasst.

2. Farbstoffsensibilisierte Solarzelle nach Anspruch 1, wobei die Substituenten Ar und Ar' beliebige aus einer Gruppe sind, bestehend aus Phenyl, Thiophen, Furan, Naphthyl-Derivate und andere polycyclische aromatische Kohlenwasserstoffe, verschmolzene heterocyclische Systeme und ihre entsprechenden Oligomer-Varianten.

3. Farbstoffsensibilisierte Solarzelle nach einem der vorhergehenden Ansprüche, wobei A Funktionen einer Carbonsäure, wie beispielsweise Cyanoacrylsäure und Rhodanin-3-Essigsäure, oder eine Phosphor- oder Schwefel-basierte Ankergruppe umfasst, wie beispielsweise in der Gestalt eines Phosphonats oder Sulfonats.

4. Farbstoffsensibilisierte Solarzelle nach einem der vorhergehenden Ansprüche, wobei n eine Kombination aus 5- oder 6-gliedrigen ungesättigten (hetero)cyclische Einheiten umfasst, welche bis zu vier Heteroatome aus den Gruppe 14 bis 16 des Periodensystems pro Ring enthalten, primär Phenyl, Thiophen, Furan, Pyrrol, Thiazol und Oxazol oder ihrer verschmolzenen und polycyclischen Varianten, wie beispielsweise Thieno-[3,2-*b*]-Thiophen, Dithieno-[3,2-*b*:2',3'-*d*]-Thiophen, Phenothiazin, Phenoxazin, 4H-silolo-[3,2-*b*:4,5-*b*']-Dithiophen und Carbazol.

5. Farbstoffsensibilisierte Solarzelle nach einem der vorhergehenden Ansprüche, wobei der organische Farbstoff D29 ist, welcher die folgende Formel aufweist: 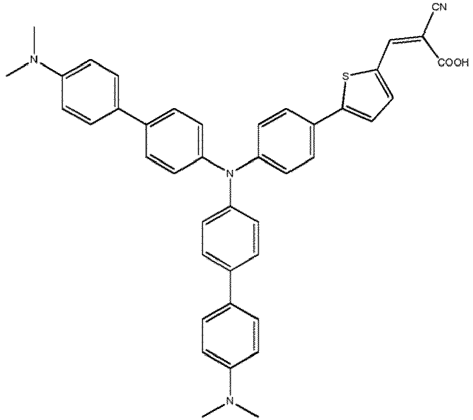 oder D35 ist, welcher die folgende Formel aufweist:

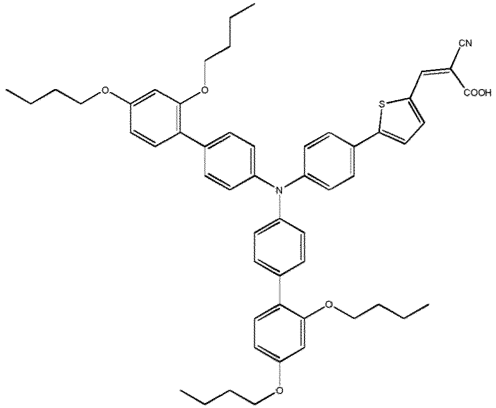

6. Farbstoffsensibilisierte Solarzelle nach einem der vorhergehenden Ansprüche, **dadurch gekennzeichnet, dass** der organische Farbstoff einen Extinktionskoeffizienten von mindestens 70000 M⁻¹cm⁻¹ aufweist.

7. Farbstoffsensibilisierte Solarzelle nach einem der vorhergehenden Ansprüche, **dadurch gekennzeichnet, dass** der Einelektronenaustausch-Redox-Mediator ein Kobalt-Komplex mit einem zentralen Kobalt-Atom mit organischen Liganden ist.

8. Farbstoffsensibilisierte Solarzelle nach einem der vorhergehenden Ansprüche, **dadurch gekennzeichnet, dass** der Einelektronenaustausch-Redox-Mediator ein Kobalt-Polypyridin-Komplex ist.

9. Farbstoffsensibilisierte Solarzelle nach einem der vorhergehenden Ansprüche, **dadurch gekennzeichnet, dass** das Material der Gegenelektrode Platin umfasst.

10. Farbstoffsensibilisierte Solarzelle nach Anspruch 1, **dadurch gekennzeichnet, dass** das Material der Gegenelektrode Kohlenstoff umfasst.

11. Farbstoffsensibilisierte Solarzelle nach Anspruch 1, **dadurch gekennzeichnet, dass** der mesoporöse Halbleiter TiO₂ umfasst.

## Revendications

1. Cellule solaire à pigment photosensible comprenant un semi-conducteur mésoporeux rendu photosensible à l'aide d'un pigment qui absorbe la lumière, une contre-électrode, et un électrolyte comprenant un médiateur redox,
dans laquelle un pigment organique qui absorbe la lumière est utilisé en combinaison avec un médiateur redox de transfert monoélectronique,
dans laquelle ledit pigment organique comprend des groupes stériques qui empêchent une recombinaison entre des électrons dans le semi-conducteur et des espèces accepteur dans ledit électrolyte, et **caractérisée en ce que**
ledit pigment organique présente la structure suivante : 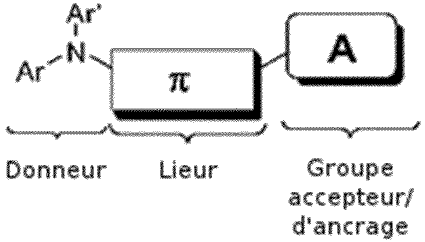 dans laquelle le donneur comprend un groupe triarylamine ayant des substituants aromatiques donneurs d'électrons Ar et Ar', dans laquelle A est un groupe d'enlèvement d'électrons, et dans laquelle **π** est une série d'une ou plusieurs unités conjuguées qui relie électroniquement les parties donneur et accepteur des molécules de pigment ; et
dans laquelle ledit pigment organique comprend une triphénylamine.

2. Cellule solaire à pigment photosensible selon la revendication 1, dans laquelle lesdits groupes Ar et Ar' sont des groupes quelconques parmi les groupes phényle, thiophène, furane, dérivés du naphthyle et d'autres hydrocarbures aromatiques polycycliques, les systèmes hétérocycliques fusionnés et leurs variantes oligomères correspondantes.

3. Cellule solaire à pigment photosensible selon l'une quelconque des revendications précédentes, dans laquelle A comprend une fonction acide carboxylique telle que l'acide cyanoacrylique et l'acide rhodanine-3-acétique, ou un groupe d'ancrage sur base de phosphore ou de soufre, tel que sous forme d'un phosphonate ou d'un sulfonate.

4. Cellule solaire à pigment photosensible selon l'une quelconque des revendications précédentes, dans laquelle **π** comprend une combinaison d'unités (hétéro)cycliques insaturées à 5 ou 6 éléments contenant jusqu'à quatre hétéroatomes appartenant au groupe 14-16 du tableau périodique par cycle, principalement des unités phényle, thiophène, furane, pyrrole, thiazole et oxazole, ou leurs variantes fusionnées et polycycliques telles que le thiéno[3,2-*b*]thiophène, le dithiéno[3,2-*b*:2',3'-*d*]thiophène, la phénothiazine, la phénoxazine, le 4H-silolo[3,2-*b*:4,5-*b*']dithiophène et le carbazole.

5. Cellule solaire à pigment photosensible selon l'une quelconque des revendications précédentes, dans laquelle ledit pigment organique est le D29, qui répond à la formule suivante : 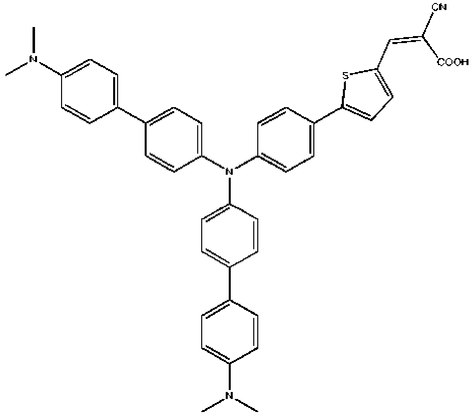 ou le D35, qui répond à la formule suivante :

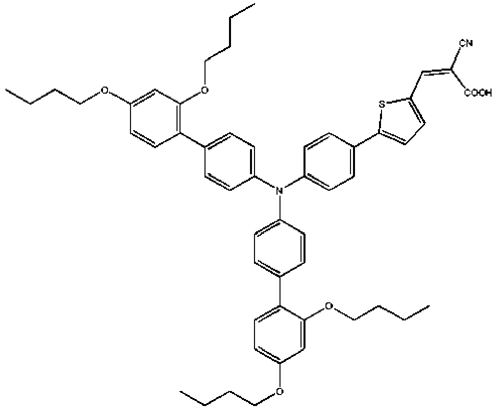

6. Cellule solaire à pigment photosensible selon l'une quelconque des revendications précédentes, **caractérisée en ce que** ledit pigment organique présente un coefficient d'extinction d'au moins 70.000 M⁻¹cm⁻¹.

7. Cellule solaire à pigment photosensible selon l'une quelconque des revendications précédentes, **caractérisée en ce que** le médiateur redox de transfert monoélectronique est un complexe de cobalt avec un atome de cobalt central et des ligands organiques.

8. Cellule solaire à pigment photosensible selon l'une quelconque des revendications précédentes, **caractérisée en ce que** ledit médiateur redox de transfert monoélectronique est un complexe polypyridine de cobalt.

9. Cellule solaire à pigment photosensible selon l'une quelconque des revendications précédentes, **caractérisée en ce que** le matériau de ladite contre-électrode comprend du platine.

10. Cellule solaire à pigment photosensible selon la revendication 1, **caractérisée en ce que** le matériau de ladite contre-électrode comprend du carbone.

11. Cellule solaire à pigment photosensible selon la revendication 1, **caractérisée en ce que** ledit semi-conducteur mésoporeux comprend du TiO₂.
